# EUROPEAN PATENT APPLICATION

(11) **EP 4 601 020 A1**
(43) Date of publication of application: **13.08.2025**
(21) Application number: 23880264.9
(22) Date of filing: 19.10.2023
(51) Int. Cl.: H01L 33/54, H01L 33/56, H01L 33/62, H01L 33/48, H01L 33/58

(54) **LIGHT-EMITTING DIODE PACKAGE**

(30) Priority: 19.10.2022 US 202263417565 P; 16.10.2023 US 202318487781
(71) Applicant: Seoul Viosys Co., Ltd., Ansan-si, Gyeonggi-do 15429 (KR)
(72) Inventor: MIN, Seung Gu, Ansan-si Gyeonggi-do 15429 (KR); LEE, Young Jin, Ansan-si Gyeonggi-do 15429 (KR)
(74) Representative: Isarpatent
(86) International application number: PCT/KR2023/016281
(87) International publication number: WO 2024/085689

(57) **Abstract**

The present disclosure relates to a light emitting diode package. In accordance with one aspect of the present disclosure, there may be provided a light emitting diode package including: a package substrate including a first substrate electrode and a second substrate electrode spaced apart from each other; a light emitting diode chip disposed on the package substrate to be electrically connected to the first substrate electrode and the second substrate electrode; and an encapsulant containing a fluorine compound and covering the light emitting diode chip to be at least partially in contact with the light emitting diode chip.

## Description

### TECHNICAL FIELD

The present disclosure relates to a light emitting diode package.

### BACKGROUND ART

In general, a light emitting diode (LED) is a semiconductor light emitting device in which when a current is applied, electrons and holes meet to emit light. The light emitting diode can emit light and is used for a backlight source of a display, a display element, a lighting device, and the like.

Meanwhile, the light emitting diode is provided in a package form by being disposed on a substrate, and a light-transmitting encapsulant is formed on the light emitting diode to improve light emission efficiency of the light emitting diode. The light-transmitting encapsulant refracts the light emitted from the light emitting diode, so that the direction in which the light travels can be controlled.

### DETAILED DESCRIPTION OF THE DISCLOSURE

### TECHNICAL PROBLEMS

An embodiment of the present disclosure is conceived in consideration of the above background, and aims to provide a light emitting diode package provided with an encapsulant containing a fluorine compound.

### MEANS FOR SOLVING PROBLEMS

In accordance with one aspect of the present disclosure, there is provided a light emitting diode package including: a package substrate including a first substrate electrode and a second substrate electrode spaced apart from each other; a light emitting diode chip disposed on the package substrate to be electrically connected to the first substrate electrode and the second substrate electrode; and an encapsulant containing a fluorine compound and covering the light emitting diode chip to be at least partially in contact with the light emitting diode chip.

Further, there may be provided the light emitting diode package in which the encapsulant is formed to have an upward convex shape.

Further, there may be provided the light emitting diode package in which a separation space, between the first substrate electrode and the second substrate electrode, surrounded by the light emitting diode chip and the package substrate is formed, and the encapsulant is in contact with the light emitting diode chip so as not to be placed in the separation space.

Further, there may be provided the light emitting diode package in which a groove is formed in at least one of the first substrate electrode and the second substrate electrode to be depressed downward from a surface thereof, the groove includes: an inner wall surface; and an outer wall surface facing the inner wall surface and positioned farther away from the light emitting diode chip than the inner wall surface to form the groove, and the encapsulant has an outer peripheral surface positioned closer to the light emitting diode chip than the outer wall surface of the groove.

Further, there may be provided the light emitting diode package in which the groove is formed such that the inner wall surface forms a predetermined angle with a surface of at least one of the first substrate electrode and the second substrate electrode.

Further, there may be provided the light emitting diode package in which the outer peripheral surface of the encapsulant is in contact with a portion where the surface of at least one of the first substrate electrode and the second substrate electrode is connected to the inner wall surface.

Further, there may be provided the light emitting diode package in which the groove is formed such that the angle formed between the inner wall surface of the groove and the surface of at least one of the first substrate electrode and the second substrate electrode is 70° to 130° inclusive.

Further, there may be provided the light emitting diode package further including a housing disposed on the package substrate and having a cavity in which the light emitting diode chip is placed, wherein the encapsulant is at least partially placed in the cavity.

Further, there may be provided the light emitting diode package in which the encapsulant is provided so that an outer peripheral surface thereof is in contact with an inner surface of the housing.

Further, there may be provided the light emitting diode package in which the encapsulant is provided so that an outer peripheral surface thereof is placed outside of the housing.

Further, there may be provided the light emitting diode package in which the housing is provided so that a distance from a surface of the package substrate to an upper end of the housing is smaller than a distance from the surface of the package substrate to an upper end of the encapsulant.

Further, there may be provided the light emitting diode package in which the first substrate electrode and the second substrate electrode include one or more materials of Au, Pd, Ni, P, Cu, and W.

Further, there may be provided the light emitting diode package in which the package substrate further includes a base on an upper surface of which the first substrate electrode and the second substrate electrode are disposed.

Further, there may be provided the light emitting diode package in which the light emitting diode chip includes: an electrode pad electrically connected to the first substrate electrode and the second substrate electrode; and a bonding agent connecting the electrode pad to each of the first substrate electrode and the second substrate electrode.

Further, there may be provided the light emitting diode package in which the encapsulant has a refractive index of 1.2 to 1.4 inclusive.

Further, there may be provided the light emitting diode package including: a package substrate; a light emitting diode chip disposed on the package substrate to be electrically connected to the package substrate; and an encapsulant containing a fluorine compound and covering the light emitting diode chip to be at least partially in contact with the light emitting diode chip, wherein the encapsulant is provided to transmit 80% or more of light emitted from the light emitting diode chip.

Further, there may be provided the light emitting diode package in which the encapsulant is provided to transmit 70% to 100% of light in an ultraviolet wavelength band.

Further, there may be provided the light emitting diode package in which the encapsulant is provided to transmit 70% to 100% of light in a visible light wavelength band.

Further, there may be provided the light emitting diode package in which the encapsulant has a thickness to transmit 80% or more of the light emitted from the light emitting diode chip.

Further, there may be provided the light emitting diode package including: a package substrate; a light emitting diode chip disposed on the package substrate to be electrically connected to the package substrate; and an encapsulant containing a fluorine compound and covering the light emitting diode chip to be at least partially in contact with the light emitting diode chip, wherein the encapsulant has a heat curing temperature of 200°C to 300°C inclusive.

### EFFECTS OF INVENTION

An embodiment of the present disclosure has the effect of improving light emission efficiency through the encapsulant containing the fluorine compound.

### BRIEF DESCRIPTION OF THE DRAWINGS

FIG. 1 is a conceptual diagram illustrating a light emitting diode package according to one embodiment of the present disclosure.
FIG. 2 is a cross-sectional view taken along line A-A' of FIG. 1.
FIG. 3 is a conceptual diagram illustrating a light emitting diode package according to a second embodiment of the present disclosure.
FIG. 4 is a conceptual diagram illustrating a light emitting diode package with modified grooves according to the second embodiment of the present disclosure.
FIG. 5 is a conceptual diagram illustrating a light emitting diode package according to a third embodiment of the present disclosure.
FIG. 6 is a conceptual diagram illustrating a light emitting diode package according to a fourth embodiment of the present disclosure.

### BEST MODE FOR IMPLEMENTING THE INVENTION

Hereinafter, specific embodiments for implementing a spirit of the present disclosure will be described in detail with reference to the drawings.

In describing the present disclosure, detailed descriptions of known configurations or functions may be omitted to clarify the present disclosure.

When an element is referred to as being 'connected' to, or 'supported' by another element, it should be understood that the element may be directly connected to, or supported by another element, but that other elements may exist in the middle.

The terms used in the present disclosure are only used for describing specific embodiments, and are not intended to limit the present disclosure. Singular expressions include plural expressions unless the context clearly indicates otherwise.

Terms including ordinal numbers, such as first and second, may be used for describing various elements, but the corresponding elements are not limited by these terms. These terms are only used for the purpose of distinguishing one element from another element.

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added.

Further, in the present disclosure, it is to be noted that expressions, such as the upper side and the lower side, are described based on the illustration of drawings, but may be modified if directions of corresponding objects are changed.

Hereinafter, a specific configuration of a light emitting diode package 1 according to the present disclosure will be described with reference to the drawings.

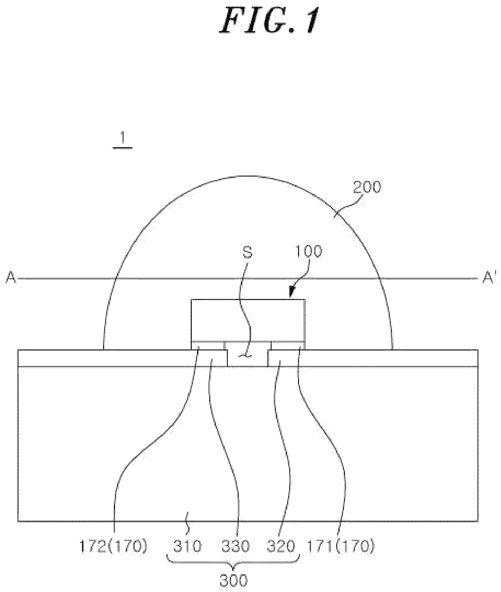

Referring to FIG. 1, a light emitting diode package 1 according to one embodiment of the present disclosure may emit light by receiving power from the outside. The light emitting diode package 1 may include a light emitting diode chip 100, an encapsulant 200, and a package substrate 300.

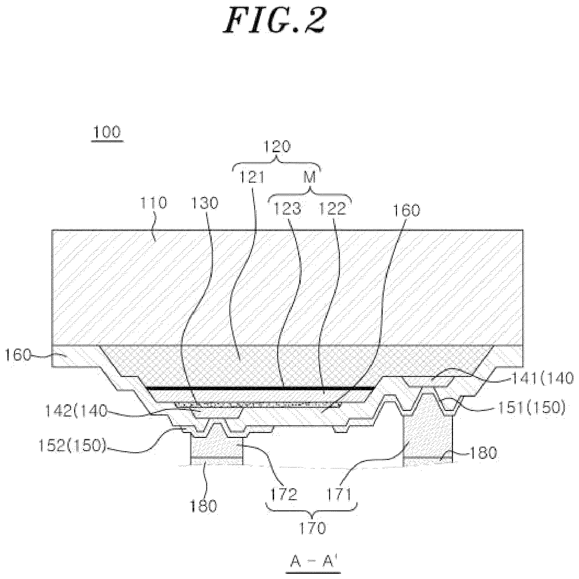

Referring to FIG. 2, the light emitting diode chip 100 may generate light. For example, the light emitting diode chip 100 may emit light in an ultraviolet wavelength band, a visible ray wavelength band, and an infrared wavelength band. As a more detailed example, the light emitting diode chip 100 may emit UV-A with a wavelength of 320 nm to 400 nm, UV-B with a wavelength of 280 nm to 320 nm, and UV-C with a wavelength of 200 nm to 280 nm. In addition, the light emitting diode chip 100 may be provided in a long rectangular shape having a major axis and a minor axis, and may have a relatively small horizontal cross-sectional area. For example, when the light emitting diode chip 100 has a rectangular shape, a length of the light emitting diode chip 100 in the longitudinal direction may be less than twice a length in the transverse direction. However, the light emitting diode chip 100 is not limited thereto and may have various shapes. The light emitting diode chip 100 may include a chip substrate 110, a light emitting structure 120, an ohmic layer 130, a contact electrode 140, a bump electrode 150, an insulating layer 160, an electrode pad 170, and a bonding agent 180.

The chip substrate 110 may be an insulating or conductive substrate. The chip substrate 110 may be a growth substrate for growing the light emitting structure 120, and may include, for example, at least one of a sapphire substrate, a silicon carbide substrate, a silicon substrate, a gallium nitride substrate, and an aluminum nitride substrate. In addition, the chip substrate 110 may have irregularities formed on at least a portion of its lower surface. For example, the irregularities formed on the chip substrate 110 may include a plurality of protrusions, and the plurality of protrusions may be formed in a regular or irregular pattern. Further, some of the plurality of protrusions on the lower surface of the chip substrate 110 may be positioned between the light emitting structure 120 and the chip substrate 110. The plurality of protrusions can improve extraction efficiency of light emitted from the light emitting structure 120.

The chip substrate 110 has a plurality of side surfaces extending from an upper surface to the lower surface of the chip substrate 110, and the side surface of the chip substrate 110 has an arbitrary angle. At least two side surfaces of the plurality of side surfaces of the chip substrate 110 may extend at different angles from the lower or upper surface of the chip substrate 110. In addition, at least one side surface of the chip substrate 110 may include a region having different inclination angles between an upper portion and a lower portion, and the chip substrate 110 may include a rough surface on the side surface. By forming an inclined surface or a rough surface on one surface of the chip substrate 110, the light emitting efficiency of light emitted from the light emitting structure 120 can be improved. Further, the side surface of the chip substrate 110 may extend to be inclined with respect to an upper surface of the package substrate 300. However, this is just an example, and the side surface of the chip substrate 110 may extend perpendicular to the upper surface of the package substrate 300.

The light emitting structure 120 is disposed on one surface of the chip substrate 110. The light emitting structure 120 may be provided in a long rectangular shape having a major axis and a minor axis similar to the chip substrate 110, but may have various shapes without being limited thereto. In addition, an area of an upper surface of the light emitting structure 120 is smaller than an area of the lower surface of the chip substrate 110, and the lower surface of the chip substrate 110 may be exposed along the periphery of the light emitting structure 120. For example, the lower surface of the chip substrate 110 of the same width may be exposed on both sides of the light emitting structure 120, but the present disclosure is not necessarily limited thereto.

Meanwhile, a width of the lower surface of the chip substrate 110 exposed in one direction may be within a range of 6:1 to 10:1 with respect to a length of the chip substrate 110 in one direction. In other words, the ratio of the width of the chip substrate 110 exposed in the longitudinal direction to the length of the chip substrate 110 in the longitudinal direction may be about 1/10 to about 1/6. In addition, the ratio of the width of the chip substrate 110 exposed in the transverse direction to the length of the chip substrate 110 in the transverse direction may also be about 1/10 to about 1/6.

The light emitting structure 120 may generate light. A total thickness of the light emitting structure 120 may be within a range of 1 µm to 10 µm. In addition, the light emitting structure 120 of a first light emitting diode 101 may include one or more of aluminum gallium arsenide (AlGaAs), gallium arsenide phosphide (GaAsP), aluminum gallium indium phosphide (AlGaInP), and gallium phosphide (GaP). Further, the light emitting structure 120 of a second light emitting diode 102 may include one or more of indium gallium nitride (InGaN), gallium nitride (GaN), gallium phosphide, aluminum gallium indium phosphide, and aluminum gallium phosphide (AlGaP). Furthermore, the light emitting structure 120 of a third light emitting diode 103 may include one or more of gallium nitride, indium gallium nitride, and zinc selenide (ZnSe). The light emitting structure 120 includes a first conductivity type semiconductor layer 121, a second conductivity type semiconductor layer 122, and an active layer 123.

The first conductivity type semiconductor layer 121 may have an inclined side surface. An inclination angle of the inclined side surface of the first conductivity type semiconductor layer 121 may be as gentle as about 60 degrees or less with respect to the lower surface of the chip substrate 110. In addition, the second conductivity type semiconductor layer 122 may be disposed on the first conductivity type semiconductor layer 121. Meanwhile, the first conductivity type semiconductor layer 121 may include n-type impurities (e.g., Si, Ge, Sn), and the second conductivity type semiconductor layer 122 may include p-type impurities (e.g., Mg, Sr, Ba). In this case, in the present embodiment, the first conductivity type semiconductor layer 121 may be an n-type semiconductor layer, and the second conductivity type semiconductor layer 122 may be a p-type semiconductor layer. However, this is merely an example, and the first conductivity type semiconductor layer 121 may include p-type impurities, and the second conductivity type semiconductor layer 122 may include n-type impurities. Further, although the first conductivity type semiconductor layer 121 is shown as a single layer in the drawings, this is merely an example, and the first conductivity type semiconductor layer 121may be formed of multiple layers or may include a superlattice layer.

The active layer 123 may include a multi-quantum well (MQW) structure, and the composition ratio of the nitride-based semiconductor may be adjusted to emit a desired wavelength. The active layer 123 may be positioned between the first conductivity type semiconductor layer 121 and the second conductivity type semiconductor layer 122.

The first conductivity type semiconductor layer 121, the second conductivity type semiconductor layer 122, and the active layer 123 may include a III-V series nitride-based semiconductor, and, for example, a nitride-based semiconductor such as (Al, Ga, In).

Meanwhile, the light emitting structure 120 may include a mesa M including the second conductivity type semiconductor layer 122 and the active layer 123. In other words, the second conductivity type semiconductor layer 122 and the active layer 123 included in the light emitting structure 120 may form a mesa M. The mesa M may be positioned on a partial region of the first conductivity type semiconductor layer 121, and the mesa M may have a thickness within a range of approximately 1 µm to 2 µm. In the present embodiment, a portion of the first conductivity type semiconductor layer 121 may be exposed outside the mesa M. In addition, in some regions, an inclined surface of the mesa M is parallel to the inclined surface of the first conductivity type semiconductor layer 121, and accordingly, the exposed surface of the lower surface of the first conductivity type semiconductor layer 121 may be limited to one side of the mesa M. However, the present embodiment is not limited thereto, and the lower surface of the first conductivity type semiconductor layer 121 may be exposed along the periphery of the mesa M. In addition, in another embodiment, a through hole (not shown) or a groove (not shown) may be formed in the mesa M to expose the first conductivity type semiconductor layer 121.

Meanwhile, when viewed from an up-down direction, the first conductivity type semiconductor layer 121 and the mesa M may be divided into a region overlapping each other and a region where the first conductivity type semiconductor layer 121 and the mesa M do not overlap. In this case, light may be emitted through the region where the first conductivity type semiconductor layer 121 and the mesa M do not overlap. For example, the region where the first conductivity type semiconductor layer 121 and the mesa M overlap may be larger than the region where the first conductivity type semiconductor layer 121 and the mesa M do not overlap.

The ohmic layer 130 may make ohmic contact with the first conductivity type semiconductor layer 121 or the second conductivity type semiconductor layer 122. The ohmic layer 130 may be disposed on the light emitting structure 120. The ohmic layer 130 may be formed of a transparent electrode. For example, the transparent electrode of the ohmic layer 130 may include a light-transmitting conductive oxide layer such as ITO (Indium Tin Oxide), ZnO (Zinc Oxide), ZITO (Zinc Indium Tin Oxide), ZIO (Zinc Indium Oxide), ZTO (Zinc Tin Oxide), GITO (Gallium Indium Tin Oxide), GIO (Gallium Indium Oxide), GZO (Gallium Zinc Oxide), AZO (Aluminum doped Zinc Oxide), FTO (Fluorine Tin Oxide), and the like. In this case, the conductive oxide layer may include various dopants. The ohmic layer 130 has excellent ohmic contact characteristics with the second conductivity type semiconductor layer 122. In other words, a conductive oxide such as ITO or ZnO has a relatively lower contact resistance with the second conductive semiconductor layer 122 compared to a metallic electrode, so that by applying a transparent electrode including the conductive oxide, a forward driving voltage Vf of the light emitting diode chip 100 can be reduced, which improves light emitting efficiency. For example, when the size of the light emitting diode chip 100 is reduced, the ohmic characteristics are greatly affected since the current density is relatively low. In this case, luminous efficiency can be more effectively improved by improving ohmic characteristics using a transparent electrode. In addition, the conductive oxide is less likely to be peeled from the nitride-based semiconductor layer than a metallic electrode, and is stable even when used for a long time. Reliability of the light emitting diode chip 100 can be improved by using a transparent electrode including the conductive oxide.

Meanwhile, the thickness of the transparent electrode is not limited, but the transparent electrode may have a thickness within a range of about 400 Å to 3000 Å. When the thickness of the transparent electrode is excessively thick, light passing through the transparent electrode may be absorbed and loss may occur, and the thickness of the transparent electrode is limited to 3000 Å or less. The transparent electrode is formed to entirely cover the lower surface of the second conductive semiconductor layer 122, thereby improving current dissipation efficiency when driving the light emitting diode chip 100. For example, side surfaces of the transparent electrode may be formed along side surfaces of the mesa M. The transparent electrode of the ohmic layer 130 may be formed on the second conductivity type semiconductor layer 122 after forming the light emitting structure 120, or may be formed on the second conductivity type semiconductor layer 122 before etching the mesa M.

The contact electrode 140 may be electrically connected to the light emitting structure 120 and the bump electrode 150. The contact electrode 140 may include a first contact pad 141 and a second contact pad 142.

The first contact pad 141 may be electrically connected to the first conductive semiconductor layer 121 and a first bump pad 151 to be described later. The first contact pad 141 may make ohmic contact with a region exposed by the mesa M in the first conductivity type semiconductor layer 121. In addition, the first contact pad 141 may include an ohmic metal layer making ohmic contact with the first conductivity type semiconductor layer 121. The first contact pad 141 may be disposed so as not to overlap the second conductive semiconductor layer 122 and the active layer 123. In this case, the insulating layer for insulating the first contact pad 141 from the second conductive semiconductor layer 122 may be omitted. Further, the first contact pad 141 may be formed on the light emitting structure 120 to which the ohmic layer 130 is connected by using, for example, a lift-off process. Meanwhile, the first contact pad 141 may be separated from the mesa M by a sufficient distance, and the separation distance may be greater than a thickness of the insulating layer 160. However, when the separation distance of the first contact pad 141 is excessively large, since the light emitting area decreases, the separation distance may be smaller than a diameter of the first contact pad 141.

The second contact pad 142 may be electrically connected to the ohmic layer 130 and a second bump pad 152 to be described later. The second contact pad 142 may make ohmic contact with the ohmic layer 130. In addition, the second contact pad 142 may be spaced apart from the first contact pad 141.

The bump electrode 150 may be electrically connected to the contact electrode 140 and the electrode pad 170. The bump electrode 150 may include the first bump pad 151 and the second bump pad 152.

The first bump pad 151 may be electrically connected to the first contact pad 141 and a first electrode pad 171 to be described later. The first bump pad 151 may be laminated on the insulating layer 160 and connected to the first contact pad 141 through an opening formed in the insulating layer 160.

The second bump pad 152 may be electrically connected to the second contact pad 142 and a second electrode pad 172 to be described later. The second bump pad 152 may be laminated on the insulating layer 160 and connected to the second contact pad 142 through an opening formed in the insulating layer 160.

The insulating layer 160 may cover the chip substrate 110, the light emitting structure 120, and the contact electrode 140. The insulating layer 160 covers a lower region and the side surface of the mesa M, and covers the first conductivity type semiconductor layer 121 exposed around the mesa M and the side surface of the first conductivity type semiconductor layer 121. In addition, the insulating layer 160 covers the lower surface of the chip substrate 110 exposed around the first conductivity type semiconductor layer 121 and covers a region between the contact electrode 140 and the mesa M. Meanwhile, the insulating layer 160 has a plurality of openings exposing the contact electrode 140. Each of the plurality of openings has a size smaller than an area of the contact electrode 140 and is limitedly positioned on the contact electrode 140. The insulating layer 160 may be an insulating reflective layer.

The insulating layer 160 includes a distributed Bragg reflector. The distributed Bragg reflector may be formed by repeatedly stacking a plurality of dielectric layers having different refractive indices, and the plurality of dielectric layers may include one or more of TiO₂, SiO₂, HfO₂, ZrO₂, Nb₂O₅, and MgF₂. For example, the insulating layer 160 may have a structure of alternately laminated TiO₂ layer/SiO₂ layer. The distributed Bragg reflector is manufactured to reflect light generated in the active layer 123 and is formed in a plurality of pairs to improve reflectance. In the present embodiment, the distributed Bragg reflector may include 10 to 25 pairs. In addition, the insulating layer 160 may include an additional insulating layer 160 together with the distributed Bragg reflector. For example, the insulating layer 160 may include an interface layer positioned below the distributed Bragg reflector, and a protective layer covering the distributed Bragg reflector to improve adhesion between the distributed Bragg reflector and the underlying layer. For example the interface layer may be formed of a SiO₂ layer, and the protective layer may be formed of SiO₂ or SiNx.

Meanwhile, the insulating layer 160 may have a thickness of about 2 µm to about 5 µm. The distributed Bragg reflector may have a reflectance of 90% or more for light generated in the active layer 123, and a reflectance close to 100% may be provided by controlling the type, thickness, and laminating cycle of the plurality of dielectric layers forming the distributed Bragg reflector. Moreover, the distributed Bragg reflector may have a high reflectance for visible light other than light generated in the active layer 123.

The electrode pad 170 may be electrically connected to the package substrate 300 so that electricity is transmitted to the light emitting structure 120. The electrode pad 170 may include the first electrode pad 171 and the second electrode pad 172.

The first electrode pad 171 may be electrically connected to the first bump pad 151 and a first substrate electrode 320 to be described later. The first electrode pad 171 may be disposed between the first bump pad 151 and the first substrate electrode 320.

The second electrode pad 172 may be electrically connected to the second bump pad 152 and a second substrate electrode 330 to be described later. The second electrode pad 172 may be disposed between the second bump pad 152 and the second substrate electrode 330.

The bonding agent 180 may connect the electrode pad 170 to the package substrate 300. The bonding agent 180 may connect the first electrode pad 171 to the first substrate electrode 320 and connect the second electrode pad 172 to the second substrate electrode 330. In addition, the bonding agent 180 may include at least one conductive material, and optionally use at least one or a combination of two or more of Au, Sn, Pd, Ni, Cu, and W. However, the conductive material included in the bonding agent is not limited thereto, and any material capable of electrical connection may be applied.

The encapsulant 200 can protect the light emitting diode chip 100 and improve light extraction efficiency of the light emitting diode chip 100. The encapsulant 200 may be disposed on the package substrate 300 to cover the light emitting diode chip 100. In addition, at least a portion of the encapsulant 200 may be disposed to contact the light emitting diode chip 100. The encapsulant 200 may be disposed to contact upper and side surfaces of the light emitting diode chip 100, and may be disposed not to contact a lower surface of the light emitting diode chip 100 facing a separation space S. In this case, the encapsulant 200 may be disposed on the package substrate 300 so as not to fill the separation space S. In this specification, the separation space S refers a space, between the first substrate electrode 320 and the second substrate electrode 330, surrounded by the light emitting diode chip 100 and the package substrate 300.

Meanwhile, the encapsulant 200 may refract light emitted from the light emitting diode chip 100. For example, the encapsulant 200 may have a refractive index of 1.2 to 1.4 inclusive. In addition, the encapsulant 200 may be provided such that an outer peripheral surface thereof forms a curved surface, and may have, for example, an upward convex shape. However, this is only an example, and the encapsulant 200 may have a downward concave shape or a flat shape. In addition, the encapsulant 200 may have a predetermined thickness, and may transmit 70% or more of light emitted from the light emitting diode chip 100. For example, the encapsulant 200 may transmit 70% or more of light in the ultraviolet wavelength band and visible light wavelength band emitted from the light emitting diode chip 100.

In addition, the encapsulant 200 may include a material having excellent heat resistance and heat dissipation, optical transparency, and light resistance to ultraviolet rays, for heat emission emitted from the light emitting diode chip 100. For example, the encapsulant 200 may contain a fluorine compound. The encapsulant 200 containing the fluorine compound may have a heat curing temperature of 200°C to 300° C inclusive. As a more detailed example, the fluorine compound of the encapsulant 200 may include one or more of fluorinated ethylene propylene (FEP), hexa fluoro propylene (HFP), penta fluoro propylene (PFP), tri fluoro ethylene (TFTP), tri fluoro chloro ethylene (TFCE), tetra fluoro ethylene (TFE), vinyl fluoride (VF), perfluoro acrylic ester (PAE), acrylic perfluoro alkyl (APA), perfluoro methyl vinyl ether (PMVE), and perfluoro propyl vinyl ether.

The package substrate 300 may support the light emitting diode chip 100 and the encapsulant 200. The package substrate 300 may be electrically connected to the light emitting diode chip 100. For example, the package substrate 300 may be a printed circuit board (PCB). The package substrate 300 may include a base 310, the first substrate electrode 320, and the second substrate electrode 330.

The base 310 may support the first substrate electrode 320 and the second substrate electrode 330. The base 310 may be provided in a rectangular shape having a major axis and a minor axis. In addition, the first substrate electrode 320 and the second substrate electrode 330 are disposed on an upper surface of the base 310 and may be exposed to the outside along the periphery. For example, a portion of the upper surface of the base 310 disposed in the separation space S between the first substrate electrode 320 and the second substrate electrode 330 may be exposed toward the light emitting diode chip 100. The base 310 may have a predetermined thickness and may be connected to an external power source. Further, the base 310 may include, for example, an alloy composed of at least one or some of Cu, Zn, Au, Ni, Al, Mg, Cd, Be, W, Mo, Si, and Fe.

The first substrate electrode 320 may transmit current to the light emitting diode chip 100. The first substrate electrode 320 may be disposed on the base 310 and electrically connected to the first electrode pad 171. In addition, the first substrate electrode 320 may be connected to the first electrode pad 171 through the bonding agent 180.

The second substrate electrode 330 may transmit current to the light emitting diode chip 100. The second substrate electrode 330 may be disposed on the base 310 to be spaced apart from the first substrate electrode 320. In this case, the second substrate electrode 330 may be electrically insulated from the first substrate electrode 320. In addition, the second substrate electrode 330 may be connected to the second electrode pad 172 through the bonding agent 180. Each of the second substrate electrode 330 and the first substrate electrode 320 may include one or more materials of Au, Pd, Ni, P, Cu, and W.

Meanwhile, the separation space S may be formed between the first substrate electrode 320 and the second substrate electrode 330. The separation space S may be a space, between the first substrate electrode 320 and the second substrate electrode 330, surrounded by the lower surface of the light emitting diode chip 100 and the upper surface of the base 310. Air may pass through the separation space S.

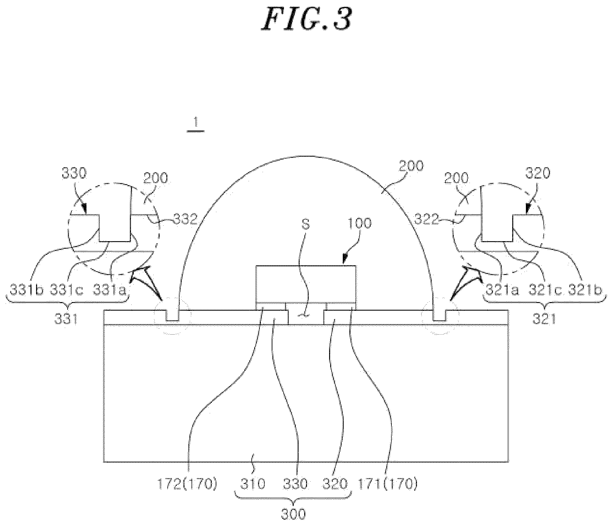

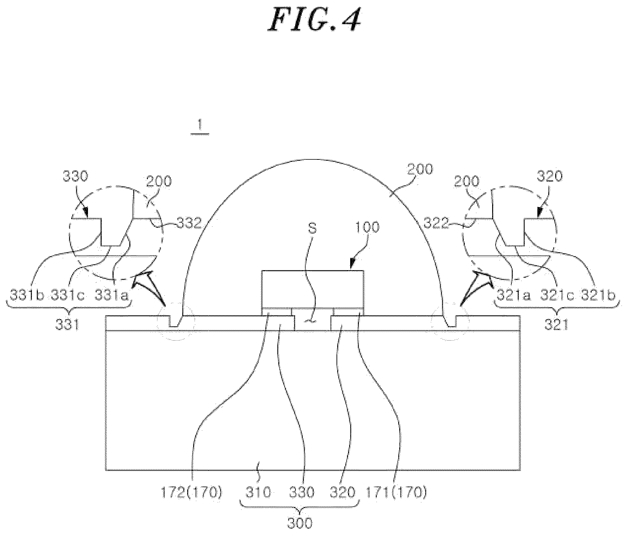

Meanwhile, in addition to the above structure, according to a second embodiment of the present disclosure, grooves 321 and 331 may be formed in the first substrate electrode 320 and the second substrate electrode 330, respectively. Hereinafter, the second embodiment of the present disclosure will be described with further reference to FIGS. 3 and 4. The description of the second embodiment description will be made mainly on the differences compared with the above-described embodiment, and the same descriptions and reference numerals are referred to the above-described embodiment.

A first groove 321 may be formed in the first substrate electrode 320. The first groove 321 may be depressed downward from an upper surface of the first substrate electrode 320. The first groove 321 may include a first inner wall surface 321a, a first outer wall surface 321b, and a first bottom surface 321c.

The first inner wall surface 321a may extend downward from a surface 322 of the first substrate electrode. Both ends of the first inner wall surface 321a may be connected to the surface 322 and the first bottom surface 321c of the first substrate electrode 320, respectively.

The first outer wall surface 321b may extend downward from the surface 322 of the first substrate electrode. The first outer wall surface 321b faces the first inner wall surface 321a and may be positioned farther away from the light emitting diode chip 100 than the first inner wall surface 321a. In addition, the first inner wall surface 321a may be formed at a predetermined angle with respect to the surface 322 of the first substrate electrode. For example, the first inner wall surface 321a may form an angle of 70° to 130° inclusive with the surface 322 of the first substrate electrode.

The first bottom surface 321c may form the bottom of the first groove 321. Both ends of the first bottom surface 321c may be connected to the first inner wall surface 321a and the first outer wall surface 321b, respectively.

A second groove 331 may be formed in the second substrate electrode 330. The second groove 331 may be depressed downward from an upper surface of the second substrate electrode 330. The second groove 331 may include a second inner wall surface 331a, a second outer wall surface 331b, and a second bottom surface 331c.

The second inner wall surface 331a may extend downward from a surface 332 of the second substrate electrode. Both ends of the second inner wall surface 331a may be connected to the surface 332 of the second substrate electrode and the second bottom surface 331c, respectively. In addition, the second inner wall surface 331a may be formed at a predetermined angle with respect to the surface 332 of the second substrate electrode. For example, the second inner wall surface 331a may form an angle of 70° to 130° inclusive with the surface 332 of the second substrate electrode.

The second outer wall surface 331b may extend downward from the surface 332 of the second substrate electrode. The second outer wall surface 331b faces the second inner wall surface 331a and may be positioned farther away from the light emitting diode chip 100 than the second inner wall surface 331a.

The second bottom surface 331c may form the bottom of the second groove 331. Both ends of the second bottom surface 331c may be connected to the second inner wall surface 331a and the second outer wall surface 331b, respectively.

Meanwhile, the area of the encapsulant 200 may be limited by the first groove 321 and the second groove 331. The outer peripheral surface of the encapsulant 200 may be placed closer to the light emitting diode chip 100 than the first outer wall surface 321b and the second outer wall surface 331b of the first groove 321 and the second groove 331, respectively. For example, the outer peripheral surface of the encapsulant 200 may come into contact with a portion where the first inner wall surface 321a and the surface 322 of the first substrate electrode are connected, and come into contact with a portion where the second inner wall surface 331a and the surface 332 of the second substrate electrode are connected. In this case, the encapsulant 200 may not be filled in the first groove 321 and the second groove 331 by the surface tension of the encapsulant 200, and come in contact with the edges of the first groove 321 and the second groove 331. However, this is just an example, and the encapsulant 200 may at least partially fill the inside of the first groove 321 and the second groove 331.

Meanwhile, in addition to such configurations, according to a third embodiment of the present disclosure, the light emitting diode package 1 may further include a housing 400.

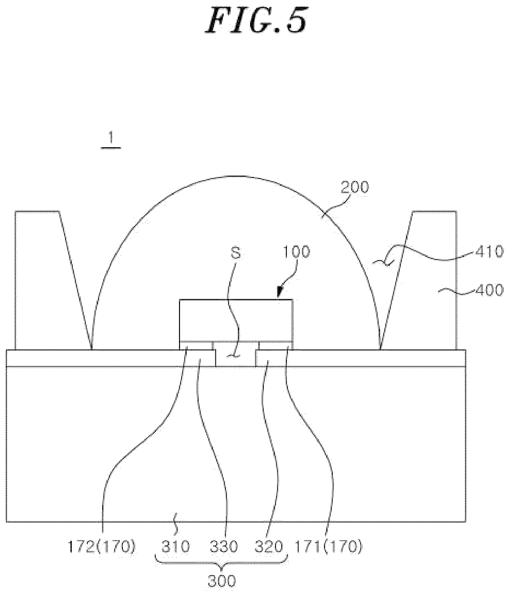

Referring to FIG. 5, the housing 400 may be disposed on the package substrate 300 to surround the light emitting diode chip 100. A cavity 410, which is an empty space, may be formed inside the housing 400, and the light emitting diode chip 100 may be placed in the cavity 410. For example, the cavity 410 may have a well-known shape such as a circle or a polygon when viewed from above. In addition, at least a portion of the encapsulant 200 may be disposed in the cavity 410. For example, the encapsulant 200 may be disposed in the cavity 410 and provided such that an outer circumferential surface contacts an inner surface of the housing 400. In this case, the outer circumferential surface of the encapsulant 200 may make line contact with a bottom of an inner surface of the housing 400 and also surface contact with the inner surface of the housing 400.

Meanwhile, the inner surface of the housing 400 may extend to be inclined with respect to the first substrate electrode 320 and the second substrate electrode 330. For example, an angle formed between the inner surface of the housing 400 and the first substrate electrode surface 322 or the second substrate electrode surface 332 may be 00 to 00 degrees inclusive. In addition, the housing 400 may be provided so that the distance from the surface of the package substrate 300 to the upper end of the housing 400 is smaller than the distance from the surface of the package substrate 300 to the upper end of the encapsulant 200.

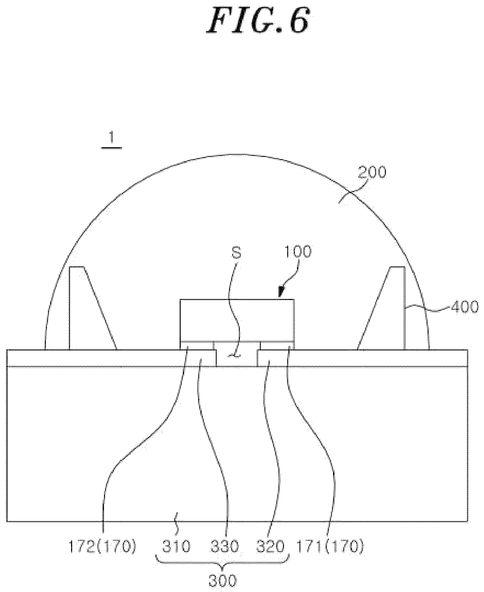

Meanwhile, in addition to such configurations, according to a fourth embodiment of the present disclosure, the encapsulant 200 may be provided to cover the housing 400. Referring to FIG. 6, the encapsulant 200 may be provided such that at least a portion thereof is placed outside the cavity 410. In this case, the outer peripheral surface of the encapsulant 200 may be placed outside the housing 400.

As such, the light emitting diode package 1 according to the embodiments of the present disclosure can prevent defects such as cracks from occurring in the encapsulant 200 even when light in the ultraviolet wavelength band is emitted for a long time. In this case, the durability of the encapsulant 200 can be maintained for a long time, which prevents the light emission efficiency of the light emitting diode chip 100 from deteriorating.

The examples of the present disclosure have been described above as specific embodiments, but these are only examples, and the present disclosure is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present disclosure. In addition, those skilled in the art can easily change or modify the disclosed embodiments based on the present specification, and it is clear that such changes or modifications also belong to the scope of the present disclosure.

## Claims

1. A light emitting diode package comprising:
a package substrate including a first substrate electrode and a second substrate electrode spaced apart from each other;
a light emitting diode chip disposed on the package substrate to be electrically connected to the first substrate electrode and the second substrate electrode; and
an encapsulant containing a fluorine compound and covering the light emitting diode chip to be at least partially in contact with the light emitting diode chip.

2. The light emitting diode package of claim 1, wherein the encapsulant is formed to have an upward convex shape.

3. The light emitting diode package of claim 1, wherein a separation space, between the first substrate electrode and the second substrate electrode, surrounded by the light emitting diode chip and the package substrate is formed, and
wherein the encapsulant is in contact with the light emitting diode chip so as not to be placed in the separation space.

4. The light emitting diode package of claim 1, wherein a groove is formed in at least one of the first substrate electrode and the second substrate electrode to be depressed downward from a surface thereof,
wherein the groove includes:
an inner wall surface; and
an outer wall surface facing the inner wall surface and positioned farther away from the light emitting diode chip than the inner wall surface to form the groove, and
wherein the encapsulant has an outer peripheral surface positioned closer to the light emitting diode chip than the outer wall surface of the groove.

5. The light emitting diode package of claim 4, wherein the groove is formed such that the inner wall surface forms a predetermined angle with a surface of at least one of the first substrate electrode and the second substrate electrode.

6. The light emitting diode package of claim 5, wherein the outer peripheral surface of the encapsulant is in contact with a portion where the surface of at least one of the first substrate electrode and the second substrate electrode is connected to the inner wall surface.

7. The light emitting diode package of claim 5, wherein the groove is formed such that the angle formed between the inner wall surface of the groove and the surface of at least one of the first substrate electrode and the second substrate electrode is 70° to 130° inclusive.

8. The light emitting diode package of claim 1, further comprising:
a housing disposed on the package substrate and having a cavity in which the light emitting diode chip is placed,
wherein the encapsulant is at least partially placed in the cavity.

9. The light emitting diode package of claim 8, wherein the encapsulant is provided so that an outer peripheral surface thereof is in contact with an inner surface of the housing.

10. The light emitting diode package of claim 8, wherein the encapsulant is provided so that an outer peripheral surface thereof is placed outside of the housing.

11. The light emitting diode package of claim 7, wherein the housing is provided so that a distance from a surface of the package substrate to an upper end of the housing is smaller than a distance from the surface of the package substrate to an upper end of the encapsulant.

12. The light emitting diode package of claim 1, wherein the first substrate electrode and the second substrate electrode include one or more materials of Au, Pd, Ni, P, Cu, and W.

13. The light emitting diode package of claim 1, wherein the package substrate further includes a base on an upper surface of which the first substrate electrode and the second substrate electrode are disposed.

14. The light emitting diode package of claim 1, wherein the light emitting diode chip includes:
an electrode pad electrically connected to the first substrate electrode and the second substrate electrode; and
a bonding agent connecting the electrode pad to each of the first substrate electrode and the second substrate electrode.

15. The light emitting diode package of claim 1, wherein the encapsulant has a refractive index of 1.2 to 1.4 inclusive.

16. A light emitting diode package comprising:
a package substrate;
a light emitting diode chip disposed on the package substrate to be electrically connected to the package substrate; and
an encapsulant containing a fluorine compound and covering the light emitting diode chip to be at least partially in contact with the light emitting diode chip,
wherein the encapsulant is provided to transmit 80% or more of light emitted from the light emitting diode chip.

17. The light emitting diode package of claim 16, wherein the encapsulant is provided to transmit 70% to 100% of light in an ultraviolet wavelength band.

18. The light emitting diode package of claim 16, wherein the encapsulant is provided to transmit 70% to 100% of light in a visible light wavelength band.

19. The light emitting diode package of claim 17, wherein the encapsulant has a thickness to transmit 80% or more of the light emitted from the light emitting diode chip.

20. A light emitting diode package comprising:
a package substrate;
a light emitting diode chip disposed on the package substrate to be electrically connected to the package substrate; and
an encapsulant containing a fluorine compound and covering the light emitting diode chip to be at least partially in contact with the light emitting diode chip,
wherein the encapsulant has a heat curing temperature of 200°C to 300°C inclusive.
